# EUROPEAN PATENT APPLICATION

(11) **EP 1 914 801 A1**
(43) Date of publication of application: **23.04.2008**
(21) Application number: 06301055.7
(22) Date of filing: 17.10.2006
(51) Int. Cl.: H01L 21/8242, H01L 27/108

(54) **DRAM manufacturing**

(71) Applicant: STMicroeletronics Crolles 2 SAS, 38920 Crolles (FR)
(72) Inventor: Caillat, Christian, 38100 Grenoble (FR)
(74) Representative: de Beaumont, Michel

(57) **Abstract**

The invention concerns a method for manufacturing, in a first region of a semiconductor wafer, DRAM cells each including a MOS control transistor (15) and a capacitor and, in a second region of the wafer, MOS transistors, the regions being covered by protection and first insulating layers (22,23), and including first vias (25) contacting the source or drain regions (16) of the transistors. The method includes the steps of depositing a second insulating layer (60), etching first openings (64) exposing a first set of the first vias and extending over gates of adjacent control transistors; depositing a dielectric layer (66) and a conductive layer (68), removing the dielectric and conductive layers to delimit, at the openings, dielectric and conductive portions (70,72) forming, with the corresponding first vias, the capacitor; depositing a third insulating layer (74); and forming second vias (76) crossing the second and third insulating layers and contacting a second set of first vias.

## Description

### FIELD OF THE INVENTION

The present invention relates to the manufacturing in monolithic form of DRAM cells. More specifically, the present invention relates to the manufacturing on a same semiconductor wafer of DRAM cells and of MOS transistors according to a process compatible with a standard CMOS process.

### BACKGROUND OF THE INVENTION

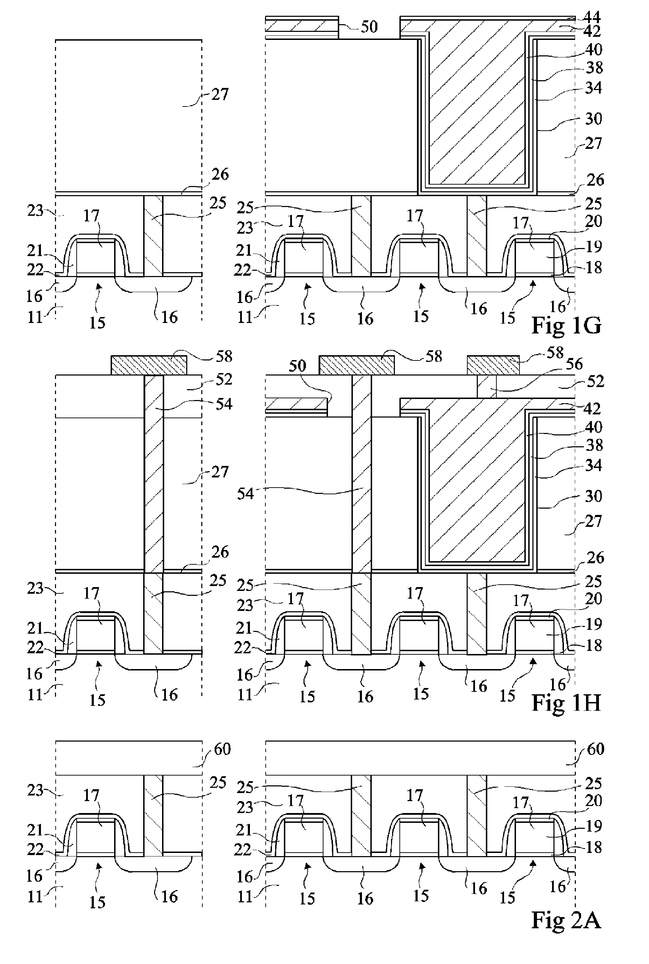

Figs. 1A to 1E and 1G and 1H are a cross-section views of a monolithic circuit including DRAM cells and MOS transistors formed according to a conventional CMOS technology.

As for Figs. 1A to 1E and 1G and 1H, DRAM cells are desired to be formed on the right-hand side of the drawings, on a first portion of a semiconductor substrate 11, typically made of silicon. On a second portion of substrate 11, shown on the left-hand side of the drawings, logic circuits including MOS transistors are desired to be formed. Hereafter, the first and second portions will be called the memory side and the logic side.

As shown in Fig. 1A, on the memory side and on the logic side, source and drain regions 16 of MOS transistors 15 as well as the associated gates 17 have been formed. Each gate 17 is conventionally having a multiple-layer structure comprising: a gate insulator 18 in contact with semiconductor substrate 11, a polysilicon layer 19, and a conductive layer 20, for example CoSi₂. Spacers 21, for example made of silicon nitride (Si₃N₄), are arranged on either side of gate 17.

A protection layer 22, for example made of silicon nitride (Si₃N₄), and a first insulating layer 23, for example made of silicon oxide, are successively deposited, on the memory side and on the logic side, over the entire structure.

First vias 25, for example made of tungsten (W), which cross first insulating layer 23 and protection layer 22 to contact source or drain regions 16, are formed on the memory side and on the logic side.

A protection layer 26, for example made of silicon nitride (Si₃N₄), is deposited, on the memory side and on the logic side, over the entire structure. A second insulating layer 27, for example made of silicon oxide, is then deposited on the memory side and on the logic side, over the entire structure.

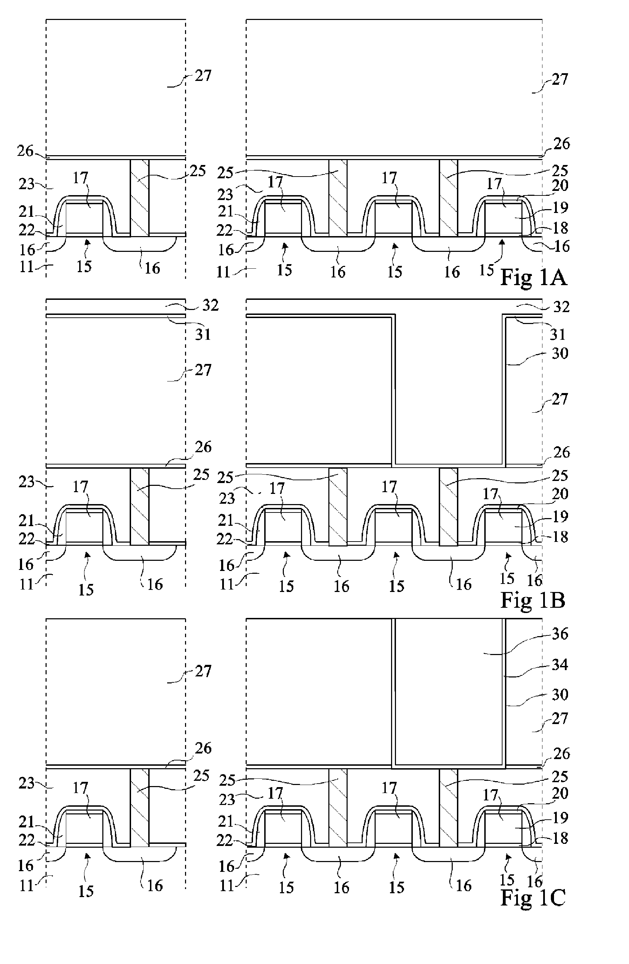

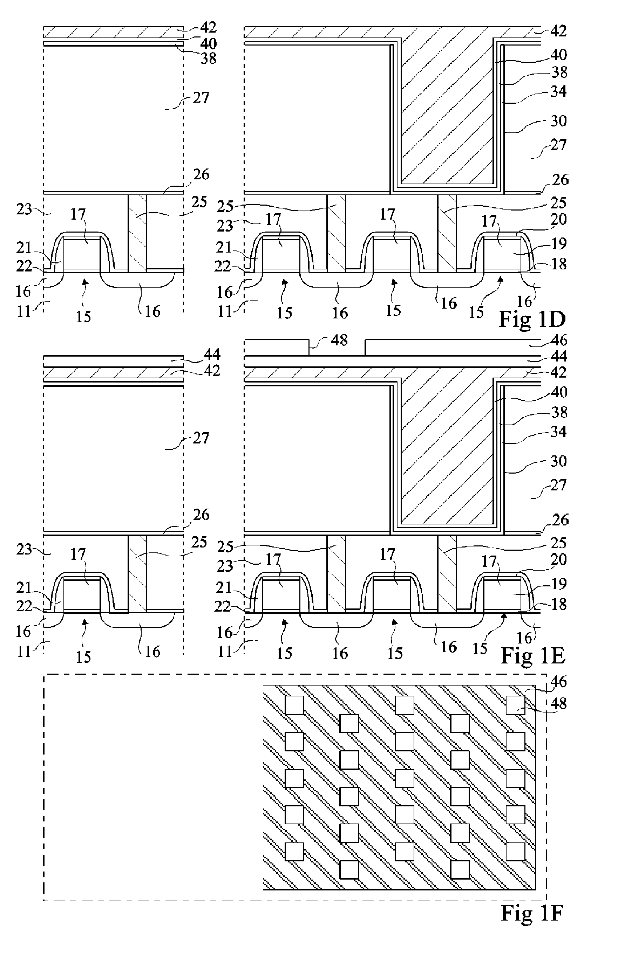

As shown in Fig. 1B, on the memory side, openings 30 having a width substantially corresponding to the pitch of the gates are etched across second insulating layer 27 to expose the upper ends of first vias 25. A first conductive layer 31 is then uniformly deposited, on the memory side and on the logic side, over the entire structure, and, in particular, on the side walls and bottom wall of each opening 30. The layer 31 can comprise a layer of titanium (Ti) and a layer of titanium nitride (TiN). A layer 32 of a filling material is then deposited, on the memory side and on the logic side, over the entire structure. In particular, the filling material completely fills the openings 30.

As shown in Fig. 1C, chemical mechanical polishing (CMP) is performed to remove the portions of layers 31, 32 covering the second insulating layer 27, and part of the second insulating layer 27, in order to leave, for each opening 30, a portion 34 of the conductive layer 31 over the side walls and bottom wall of each opening 30, and a portion 36 of the filling material filling each opening 30. Portion 34 corresponds to the bottom electrodes of the capacitor of the DRAM cell.

As shown in Fig. 1D, portion 36 of the filling material is removed and a layer 38 of a dielectric material and a second conductive layer 40 are uniformly deposited, on the memory side and on the logic side, over the entire structure. The second conductive layer 40 can have the same structure as the first conductive layer 34. Finally, a third conductive layer 42, for example made of tungsten, is deposited, on the memory side and on the logic side, over the entire structure, and, in particular, so that it completely fills the openings 30. Second and third conductive layers 40, 42 form the top electrodes of the capacitors of the DRAM cells.

As shown in Fig. 1E, a hard mask layer 44, for example made of silicon oxide, and a photoresist layer 46 are deposited on the memory side and on the logic side over the entire structure. Through a photolithography and etching step, openings 48 are made in the photoresist layer 46, at a location where the layers 38, 40, 42 are to be removed.

Fig. 1F is a schematic top view of the photoresist layer 46 after the photolithography and etching step and illustrates an exemplary disposition of the openings 48, the remaining portions of the photoresist layer 46 being shown by the area having diagonal striped lines. On the logic side, left-hand side of Fig. 1F, the entire photoresist layer 46 is removed and on the memory side, right-hand side of Fig. 1F, the photoresist layer 46 is only removed where vias are required for making contact with the transistors.

As shown in Fig. 1G, layers 38, 40, 42, 44 are completely etched on the logic side. On the memory side, openings 50 are etched through layers 38, 40, 42, 44 only where vias are required for making contact with the transistors. On the memory side, outside the openings 50, the insulating layer 44 may be also etched down through a part of its thickness.

As shown in Fig. 1H, a third insulating layer 52, for example made of silicon oxide, is deposited on the memory side and on the logic side, over the entire structure. Since the openings 50 tend to cause depressions in the top surface of the third insulating layer 52, a chemical mechanical polishing step is performed to planarize insulating layer 52. Second vias 54, for example made of tungsten, which cross the second and third insulating layers 27, 52 to join, on the logic side, all first vias 25, and to join, on the memory side, some of first vias 25, are formed on the memory side and on the logic side. Vias 56, which cross third insulating layer 52 to make contact with conductive layer 42, are also formed.

Conductive tracks 58 of the first metallization level of the circuit are formed on the third insulating layer 52, to make contact with vias 54, 56.

With such a structure, the top electrodes of the capacitors of the DRAM cells can be electrically connected together. This is advantageous since it allows a single voltage reference for the DRAM cells to be easily obtained. Moreover, during the manufacturing process, it reduces the risks of undesirable breakdown of the dielectric layers 38 of DRAM cells.

However, the previously described manufacturing method has several drawbacks:
Firstly, the manufacturing of the vias 54 is difficult. Indeed, for such a DRAM memory structure, in which the spacings between transistors is mainly imposed by the CMOS process used, the dimensions of the capacitors, and thus their capacitance, are a direct function of the thickness of second insulating layer 27. It is then desirable to form the second insulating layer 27 with a high thickness. However, it is also generally desired to form vias having the smallest possible diameter, and those skilled in the art know that the formation of vias of small diameter in an insulating layer of high thickness is difficult. In particular, it is difficult to fill an opening of small diameter with a conductive material to ensure a satisfactory electrical connection. The ratio between the thickness of the insulating layer and the diameter of the opening in which the via must be formed is called the aspect ratio. The higher this ratio, the harder the realization of the via. For vias having a 120 nm diameter, according to current technologies where the channel width of transistors is 90 nm, maximum aspect ratios in the order of 6-7 can be reached, which limits the combined thickness of the insulating layers 27, 52 to values in the order of 200 and 500 nm respectively;
Secondly, the combination of layers 38, 40, 42 (comprising materials such as titanium, titanium nitride, tungsten, and a dielectric material) is difficult to etch by a common anisotropic etching step and requires the use of hard mask 44. There is a risk of defects due to this etching step (risk of metallic residues or dirty interfaces). Moreover, those skilled in the art know that it is difficult to simultaneously remove large portions of these layers (on the logic side) and at the same time remove small portions of theses layers (to manufacture the vias on the memory side);
Thirdly, the method of manufacturing the DRAM cells requires the use of a high number of masks: a first mask for the etching of openings 30 (Fig. 1B), a second mask for the etching of layers 38, 40, 42, 44 (Fig. 1E) and a third mask for forming vias 54 (Fig. 1H). Such masks are very expensive and difficult to manufacture;
Fourthly, the positioning of each of these masks is critical. Indeed, the positioning of the third mask must be made with high precision to correctly align vias 54 with vias 25. Moreover, the positioning of the first and second masks must be made with high precision. Indeed, the relative position between the second and third masks determines the minimal distance between vias 54 and adjacent top electrodes and the relative position between the first and second masks determines the overlay between the top and bottom electrodes; and
Fifthly, the method of manufacturing the DRAM cells requires two chemical mechanical polishing steps: a first CMP step to delimit the bottom electrodes and a second CMP step to planarize the third insulating layer 52. Such CMP steps are delicate to implement.

### SUMMARY OF THE INVENTION

The present invention aims at providing a method for manufacturing DRAM cells and MOS transistors on a same semiconductor wafer according to a process compatible with a standard CMOS process and which does not present at least one of the drawbacks previously mentioned.

To attain this purpose and others, an aspect of the present invention provides a method for manufacturing, in a first region of a semiconductor wafer, DRAM cells each including a MOS control transistor and a capacitor and, in a second region of the wafer, MOS transistors, the first and second regions being covered by a protection layer and by a first insulating layer, and including first vias crossing the first insulating layer and the protection layer and contacting the source or drain regions of the transistors, including the steps of depositing a second insulating layer, etching at the level of the first region openings exposing a first set of the first vias and extending over gates of adjacent control transistors; depositing a dielectric layer and a conductive layer, removing the dielectric and conductive layers to delimit, at the openings, dielectric portions and conductive portions forming, with the corresponding first vias, the capacitors; depositing a third insulating layer; and forming at the level of the first and second regions second vias crossing the second and third insulating layers and contacting a second set of first vias.

According to an embodiment of the present invention, the method includes the step of forming, at the same time as forming the second vias, third vias, at the level of the first region, crossing the third insulating layer and contacting the conductive portions.

According to an embodiment of the present invention, the protection layer covering the gates of the control transistors forms an etch stop used when etching the openings.

According to an embodiment of the present invention, the protection layer includes silicon nitride.

According to an embodiment of the present invention, at least some of the openings are joined with each other.

According to an embodiment of the present invention, the first vias of the first set of vias are formed with a rectangular section.

According to an embodiment of the present invention, the sum of the thicknesses of the etched second insulating layer and the third insulating layer is equal to the thickness of the first insulating layer plus or minus 10 %.

According to an embodiment of the present invention, the first, second and/or third vias are made of a metal or are made of a metallic core covered at least on their side walls by a nitride metal.

According to an embodiment of the present invention, the conductive layer is made of a metal or a nitride metal.

According to an embodiment of the present invention, the dielectric and conductive layers are removed by a chemical mechanical polishing step.

### BRIEF DESCRIPTION OF THE DRAWINGS

The foregoing and other purposes, features, aspects and advantages of the invention will become apparent from the following detailed description of embodiments, given by way of illustration and not limitation with reference to the accompanying drawings.

Figs. 1A to 1E and 1G and 1H, previously described, are cross-section views of a monolithic circuit including DRAM cells and MOS transistors formed according to a conventional CMOS technology, while Fig. 1F shows a top view of the etched photoresist layer illustrated in Fig. 1E;

Figs. 2A, 2B and 2D to 2G are cross-section views of a same integrated circuit wafer at different successive steps of its manufacturing according to an embodiment of the present invention, while Fig. 2C shows a top view of the etched photoresist layer illustrated in Fig. 2B;

Fig. 3 is a schematic and partial top view of a DRAM according to an embodiment of the present invention; and

Fig. 4 is a schematic and partial top view of a DRAM according to another embodiment of the present invention.

### DETAILED DESCRIPTION OF THE INVENTION

For clarity, same elements have been designated with the same references in the different drawings and, furthermore, as usual in the representation of integrated circuits, the various drawings are not drawn to scale.

An embodiment of the present invention will be discussed hereafter in relation with Figs. 2A to 2G.

As for Fig. 2A, DRAM cells are desired to be formed, on the right-hand side of the drawings, on a first portion of a semiconductor substrate 11, typically made of silicon. On a second portion of substrate 11, on the left-hand side of the drawings, logic circuits including MOS transistors are desired to be formed. Hereafter, the first and second portions will be called the memory side and the logic side.

As shown in Fig. 2A, on the memory side and on the logic side, source and drain regions 16 of MOS transistors 15 as well as the associated gates 17 have been formed. Each gate 17 is conventionally having a multiple-layer structure comprising: a gate insulator 18 in contact with semiconductor substrate 11, a polysilicon layer 19, and a conductive layer 20, for example formed of CoSi₂. Spacers 21, for example made of Si₃N₄, are arranged on either side of gate 17.

A protection layer 22, for example made of silicon nitride (Si₃N₄) and a first insulating layer 23, for example made of silicon oxide, are successively deposited, on the memory side and on the logic side, over the entire structure. As an example, protection layer 22 has a thickness of approximately 30 nm and first insulating layer 23 has a thickness of approximately 300 nm.

First vias 25, for example made of tungsten, which cross first insulating layer 23 and protection layer 22 to make contact with source or drain regions 16, are formed on the memory side and on the logic side. Alternatively, each via 25 can have a core of tungsten (W) covered on its side walls and bottom wall by a layer or titanium nitride (TiN).

A second insulating layer 60, for example silicon oxide, is deposited, on the memory side and on the logic side, over the entire structure. The thickness of the second insulating layer is, for example, approximately 100 nm and is less than the thickness of the second insulating layer 27 previously described in relation to Fig. 1A.

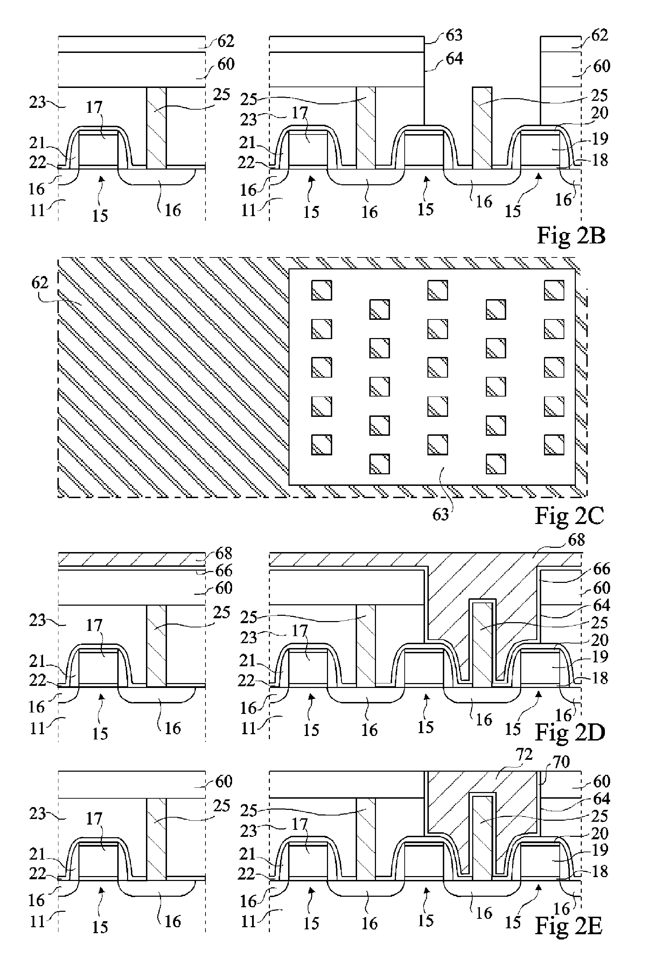

As shown in Fig. 2B, a photoresist layer 62 is deposited, on the memory side and on the logic side, over the entire structure. Openings 63 are formed in the photoresist layer 62 by a photolithography and etching step. Openings 64 are then etched in the first and second insulating layers 23, 60 in a prolongation of openings 63. The protection layer 22 acts as a stop layer for the etching of the first and second insulating layers 23, 60.

Fig. 2C is a schematic top view of the photoresist layer 62 and illustrates an example of pattern of openings 63, the remaining portions of photoresist layer 62 being shown by the area having diagonal striped lines. On the logic side (left-hand side of Fig. 2C), the entire photoresist layer 62 is left in place and on the memory side (right-hand side of Fig. 2C), the photoresist layer 62 is only removed at openings 63. As shown in Fig. 2C, openings 63 are joined such that, once etched using photoresist layer 62, openings 64 communicate and form a single opening.

As shown in Fig. 2D, the remaining portions of the photoresist layer 62 are removed, and a layer 66 of a dielectric material is uniformly deposited, on the memory side and on the logic side, over the entire structure. The dielectric material can be alumina (Al₂O₃), zirconium oxide (ZrO₂), hafnium oxide (HfO₂), etc. The thickness of layer 66 can be in the range of 5 to 10 nm typically. Layer 66 can be deposited by an Atomic Layer Deposition method (ALD). Moreover, a layer 68 of a conductive material is deposited, on the memory side and on the logic side, over the entire structure. In particular, layer 68 completely fills the openings 64. Layer 68 can be made of tungsten (W), titanium nitride (TiN), tungsten nitride (WN), or of a combination of two or more of these materials. For example, a layer or several layers of the conductive material can be deposited by an Atomic Layer Deposition method and the rest of the conductive material of layer 68 can be deposited by a Chemical Vapor Deposition method (CVD).

As shown in Fig. 2E, a chemical mechanical polishing step (CMP) or alternately an etch-back step is performed to remove the portions of layers 66, 68 covering the second insulating layer 60 and part of the second insulating layer 60 in order to leave portions 70 of dielectric material over the side walls and bottom wall of openings 64, and portions 72 of the conductive material filling openings 64. Vias 25 in contact with portions 70 form the bottom electrodes of the capacitors of the DRAM cells and conductive portions 72 forms the top electrodes of the capacitors. A DRAM memory wherein the top electrodes of the capacitors of the DRAM cells are electrically connected together is thus obtained.

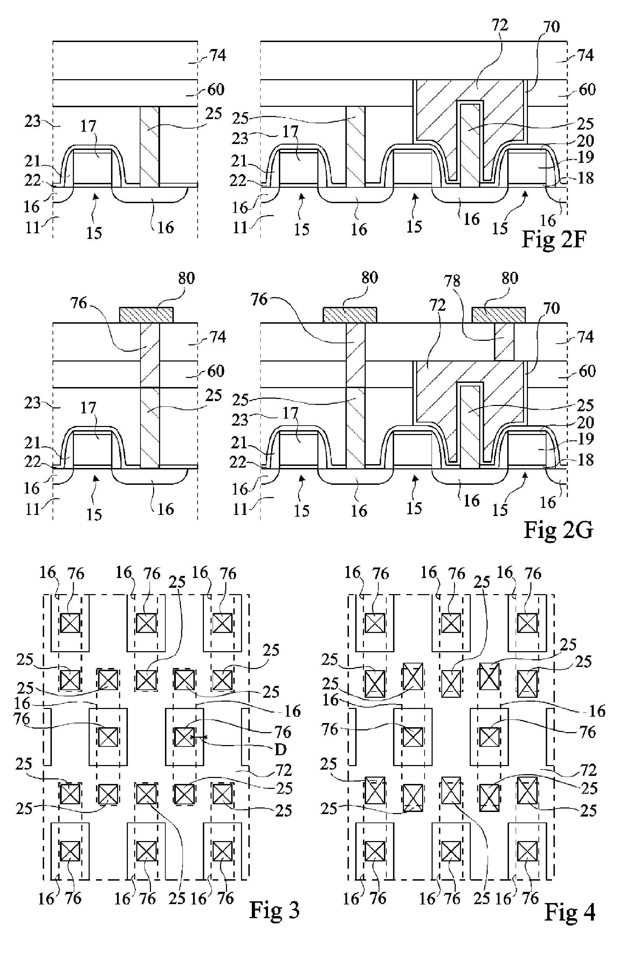

As shown in Fig. 2F, a third insulating layer 74, for example made of silicon oxide, is deposited, on the memory side and on the logic side, over the entire structure. As an example, the sum of the thicknesses of the second and third insulating layers 60, 74 is approximately equal to the thickness of the first insulating layer 23, plus or minus 10 %, for example, approximately 300 nm.

As shown in Fig. 2G, second vias 76, for example made of tungsten, which cross second and third insulating layers 60, 74 to join, on the logic side, all first vias 25, and to join, on the memory side, some of first vias 25, are formed on the memory side and on the logic side. Vias 78 which cross third insulating layer 74 to make contact with conductive portions 72 are also formed. Conductive tracks 80 of the first metallization level of the circuit are formed on the third insulating layer 74, to contact vias 76, 78. Alternately, vias 76, 78 can have a core of tungsten (W) covered on its side walls and bottom wall by a layer of titanium nitride (TiN).

Fig. 3 is a schematic and partial top view of an example of the memory side of a circuit obtained by the manufacturing method described above. The dashed lines delimit source and drain regions 16 of MOS transistors 15. Squares with a cross labeled 25 correspond to vias 25 forming bottom electrodes of the capacitors of the DRAM cells. Squares with a cross labeled 76 correspond to vias contacting source and regions 16 of MOS transistors 15. The remaining solid lines correspond to top electrodes 72. D is the minimal distance between via 76 and adjacent top electrode 72 and can be easily made superior to the common minimal distance required in CMOS technology.

Fig. 4 is a view similar to Fig. 3 wherein the vias 25 forming the bottom electrodes of the capacitors of the DRAM cells have a rectangular section. This increases, for each DRAM cell, the surface area of the top and bottom electrodes that are facing, and, hence, increases the capacitance of the DRAM cell.

Embodiments of the present invention have many advantages:
Firstly, no vias with high aspect ratio have to be formed since the sum of the thicknesses of the second and third insulating layers 60, 74 is not linked to the capacitance of the capacitors of the DRAM cells and, thus, can be reduced.
Secondly, the delimitation of top electrodes is obtained by a chemical mechanical polishing step and not by an anisotropic etching of the layers comprising the top electrode and the dielectric layer, which is easier to implement.
Thirdly, the manufacturing method requires only two masks, a first mask for the delimitation of the top electrodes and a second mask for the formation of the vias contacting the transistors.
Fourthly, only the positioning of the mask used to manufacture vias 76 is critical. Indeed, the positioning of the mask used for the delimitation the top electrodes is less critical since the distance between vias 76 and top electrodes can be easily chosen to be greater than the state-of-the-art mask positioning precision.
Fifthly, the manufacturing method requires only one chemical mechanical step for the delimitation of the top electrodes.
Sixthly, the manufacturing method does not comprise an etching step wherein simultaneously large and small portions of a material have to be etched. Indeed, in etching the openings 64 used to form the top electrodes, only small portions of the insulating layers 23, 60 are etched.

Having thus described at least one illustrative embodiment of the invention, various alterations, modifications and improvements will readily occur to those skilled in the art. In particular, some steps may be adapted by those skilled in the art. For example, the protection layer, as well as the insulating layers, may consist in a multiple-layer formed of several layers. Moreover, if it is not desirable that all the top electrodes of the capacitors of the DRAM cells are electrically connected to each other, isolate openings 64 can be made for each DRAM cell or for groups of DRAM cells. Such alterations, modifications and improvements are intended to be within the spirit and scope of the invention. Accordingly, the foregoing description is by way of example only and is not intended to be limiting. The invention is limited only as defined in the following claims and the equivalent thereto.

## Claims

1. A method for manufacturing, in a first region of a semiconductor wafer, DRAM cells each including a MOS control transistor (15) and a capacitor and, in a second region of the wafer, MOS transistors (15), the first and second regions being covered by a protection layer (22) and by a first insulating layer (23), and including first vias (25) crossing the first insulating layer and the protection layer and contacting the source or drain regions (16) of the transistors, including the steps of:
- depositing a second insulating layer (60), etching at the level of the first region openings (64) exposing a first set of the first vias and extending over gates of adjacent control transistors;
- depositing a dielectric layer (66) and a conductive layer (68), removing the dielectric and conductive layers to delimit, at the openings, dielectric portions (70) and conductive portions (72) forming, with the corresponding first vias, the capacitors;
- depositing a third insulating layer (74); and
- forming at the level of the first and second regions second vias (76) crossing the second and third insulating layers and contacting a second set of first vias.

2. A method according to claim 1, including the step of forming, at the same time as forming the second vias (76), third vias (78), at the level of the first region, crossing the third insulating layer (74) and contacting the conductive portions (72).

3. A method according to claim 1, wherein the protection layer (22) covering the gates of the control transistors (15) forms an etch stop used when etching the openings (64).

4. A method according to claim 1, wherein the protection layer (22) includes silicon nitride.

5. A method according to claim 1, wherein at least some of the openings (64) are joined with each other.

6. A method according to claim 1, wherein the first vias (25) of the first set of vias are formed with a rectangular section.

7. A method according to claim 1, wherein the sum of the thicknesses of the etched second insulating layer (60) and the third insulating layer (74) is equal to the thickness of the first insulating layer (23) plus or minus 10 %.

8. A method according to claim 2, wherein the first, second and/or third vias (25, 76, 78) are made of a metal or are made of a metallic core covered at least on their side walls by a nitride metal.

9. A method according to claim 1, wherein the conductive layer (68) is made of a metal or a nitride metal.

10. A method according to claim 1, wherein the dielectric and conductive layers (66, 68) are removed by a chemical mechanical polishing step.
